# FASCICULE DE BREVET EUROPEEN

(11) **EP 1 066 741 B1**
(45) Date de publication et mention de la délivrance du brevet: **28.11.2001**
(21) Numéro de dépôt: 99909079.8
(22) Date de dépôt: 23.03.1999
(51) Int. Cl.: H05K 7/00, H05K 7/02

(54) **STRUCTURE DE CIRCUITS ELECTRONIQUES A ENCOMBREMENT OPTIMISE EN FONCTION DU VOLUME DISPONIBLE**
ELEKTRONISCHE SCHALTUNGSSTRUKTUR MIT OPTIMISIERUNG DES PLATZBEDARFS IN ABHANGIGKEIT VOM VORHANDENEN VOLUMEN
ELECTRONIC CIRCUIT STRUCTURE WITH OPTIMISED SPACE REQUIREMENT ACCORDING TO AVAILABLE VOLUME

(30) Priorité: 27.03.1998 FR 9803828
(43) Date de publication de la demande: 10.01.2001
(73) Titulaire: Thales, 75008 Paris (FR)
(72) Inventeur: CANAL, Yves, 94117 Arcueil Cedex (FR); LIGUORO, Corinne, 94117 Arcueil Cedex (FR); POUDEROUS, Emile, 94117 Arcueil Cedex (FR)
(86) Numéro de dépôt international: FR9900681
(87) Numéro de publication internationale: WO9951072

(56) Documents cités:
- EP-A- 0 584 669
- FR-A- 2 570 221

## Description

La présente invention se rapporte à une structure de circuits électroniques à encombrement optimisé en fonction du volume disponible.

Lorsque des aéronefs, en particulier des avions de combat, doivent porter des équipements électroniques encombrants, et que la place disponible est réduite, et surtout lorsque ces équipements nécessitent une « vue » dégagée par exemple vers l'avant des aéronefs, on dispose ces équipements dans le nez du porteur, dans le pied dé dérive, dans les ailes ou dans des « pods » (conteneurs spéciaux) fixés sous l'appareil. La forme de ces emplacements où l'on peut loger les équipements est souvent très accidentée et/ou leurs dimensions sont faibles, ce qui empêche de tirer parti de tout le volume disponible, du fait que ces équipements sont généralement enfermés dans des boîtiers de formes géométriques simples, qui ne peuvent pas s'adapter auxdites formes accidentées.

La présente invention a pour objet une structure de circuits électroniques dont la forme extérieure puisse être facilement adaptée de façon optimale à pratiquement n'importe quelle forme de logement destiné à recevoir ces équipements, et ce, sans perturber le fonctionnement des équipements, dont les composants puissent être le plus divers possible, tout en ayant des performances optimales.

On connaît d'après le document EP-A-0 584 669 une structure de circuits électroniques disposée dans un volume de forme cylindrique circulaire, mais une telle disposition ne peut être adaptée à des volumes du type précité, à savoir en particulier des volumes à section en U dont la partie courbe a un faible rayon de courbure.

La structure conforme à l'invention est une structure de circuits à encombrement optimisé en fonction du volume disponible, comportant un empilement de couches planes comprenant au moins un circuit électronique, cet empilement étant disposé dans un logement présentant une forme frontale à faible rayon de courbure bordant au moins une surface plane, et elle est caractérisée par le fait que les plans des strates de la structure sont parallèles à cette surface plane et que la partie frontale de ces strates épouse le plus fidèlement possible la forme à faible rayon de courbure.

La présente invention sera mieux comprise à la lecture de la description détaillée de plusieurs modes de réalisation, pris à titre d'exemples non limitatifs et illustrés par le dessin annexé, sur lequel :
- la figure 1 est une vue en coupe simplifiée d'un volume à profil à faible rayon de courbure, dans lequel les structures connues ne permettent de loger que des antennes, sans leurs circuits (déphaseurs, alimentation...), en laissant inoccupé un volume non négligeable,
- la figure 2 est une vue simplifiée en coupe d'un volume dans lequel l'invention permet de disposer des antennes, avec leurs circuits, ces antennes pouvant être orientées dans des directions très différentes,
- les figures 3 à 5 sont respectivement une vue simplifiée en perspective éclatée et des vues en coupe selon IV-IV et V-V de la figure 3, ces figures se rapportant à un exemple de réalisation d'une structure conforme à l'invention, et
- la figure 6 est une vue simplifiée en coupe d'un volume dans lequel est disposée une structure conforme à l'invention, cette vue ne montrant que les emplacements de deux antennes dirigées dans des directions orthogonales, avec les plongeurs relatifs à ces deux antennes, ces plongeurs faisant partie d'une même couche de la structure multicouche de l'invention.

L'invention est décrite ci-dessous en référence à une structure d'antennes et de circuits associés pour des équipements tels que des équipements de guerre électronique, de radars aéroportés, de matériel de télécommunications, mais il est bien entendu qu'elle n'est pas limitée à ces seules applications, et qu'elle peut être mise en oeuvre pour réaliser des structures intégrant différents éléments mécaniques et/ou électriques et/ou électroniques et/ou optiques, et/ou thermiques en particulier pour permettre de loger ces éléments dans des volumes qui étaient estimés jusqu'à présent trop petits et/ou à formes trop « torturées » pour permettre d'y loger optimalement des éléments qui étaient traditionnellement disposés dans des boîtiers, généralement de forme parallélépipédique, laissant trop de volumes inoccupés.

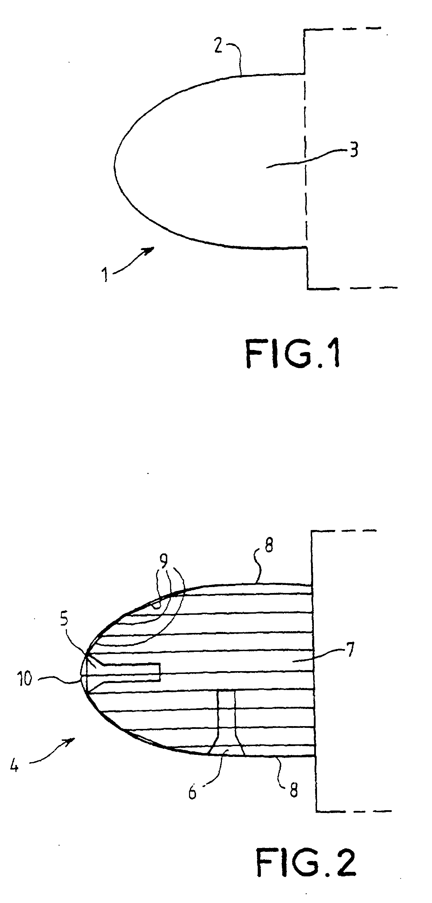

La portion 1 de volume représentée en figure 1 est par exemple la partie antérieure du bord d'attaque de l'aile 2 d'un avion de chasse. Dans cette partie antérieure, on ne loge généralement rien. Cette portion a, en coupe une forme approximativement en « U », dont la partie courbe est dirigée vers l'avant de l'avion. Cette partie courbe a un faible rayon de courbure, et est donc très difficilement logeable. Son volume intérieur 3 est inoccupé, car trop faible pour permettre d'y loger les boîtiers des circuits se trouvant en amont de l'antenne (déphaseurs, alimentation, ...). Ces boîtiers ont une forme générale parallélépipédique dont même la plus petite dimension est supérieure à la distance D séparant les branches du « U ».

On a schématiquement représenté en figure 2 une portion de volume 4, similaire à la portion 1 de la figure 1, dans laquelle l'invention permet de loger non seulement des antennes 5 dirigées vers l'avant de l'avion porteur, mais également des antennes 6 dirigées vers le sol, ainsi que des circuits, référencés 7 dans leur ensemble, réalisés de façon intégrée avec les antennes, sous forme stratifiée, comme expliqué ci-dessous. Selon l'invention, les plans des strates sont parallèles aux surfaces les plus importantes du volume disponible, en particulier aux surfaces planes, telles que les surfaces 8 de la portion de volume 4. Il en résulte que les parties frontales 9 des strates épousent le plus fidèlement possible la forme frontale 10 de la portion de volume 4, qui a un (ou plusieurs) faible (s) rayon (s) de courbure.

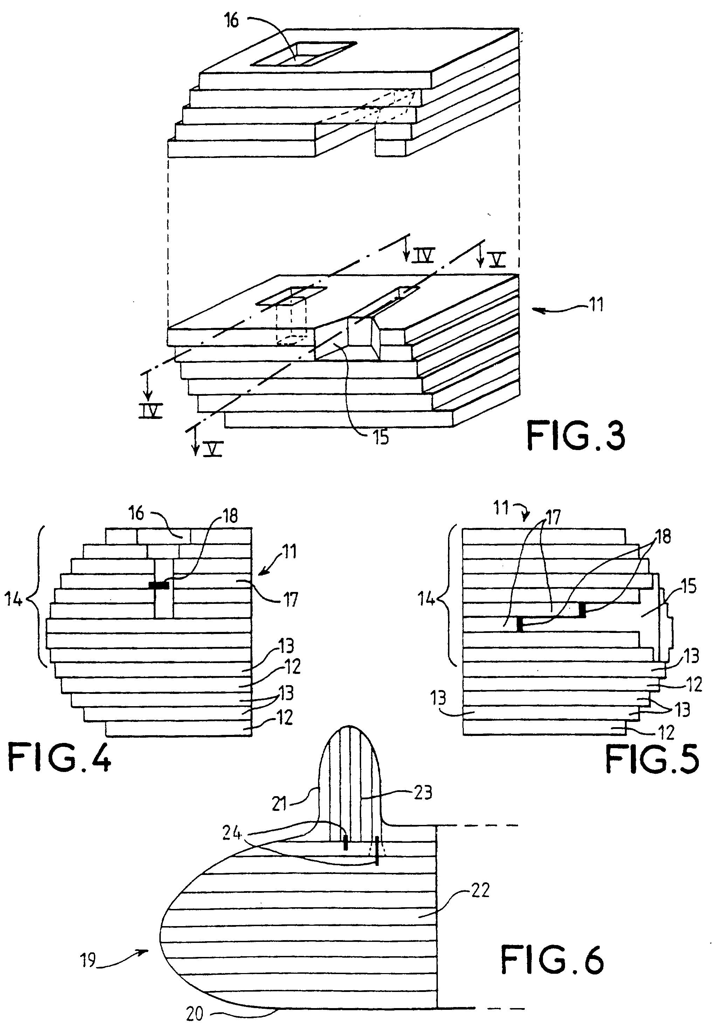

On a représenté, de façon plus détaillée, sur les figures 3 à 5, un exemple simplifié de structure stratifiée 11, similaire à la structure 7. Cette structure 11 comporte un empilement de couches dont les contenus, épaisseur, nature peuvent être très divers.

Certaines couches de la structure 11, telles que les couches 12 peuvent être des couches en matériau isolant ou en matériau absorbant les chocs et vibrations. Ces couches 12 sont, par exemple les couches externes de la structure, ainsi que des couches intermédiaires isolant entre elles des couches 13 comportant des éléments conducteurs non isolés. Des éléments peuvent être compris ou formés dans plusieurs couches successives 14. Ces éléments sont, par exemple, des antennes intégrées. A cet effet, les couches 14 comportent des découpes formant directement les cornets 15, 16 des antennes (ou tout autre type d'antenne), intégrées dans la structure 11. Les cornets tels que le cornet 15 ont leur axe dirigé parallèlement aux plans des strates, tandis que l'axe des cornets tels que le cornet 16 est perpendiculaire à ces plans des strates. Bien entendu, les axes d'autres cornets pourraient être obliques par rapport aux plans des strates.

D'autres couches comportent des circuits électroniques simples et/ou complexes. Ainsi, par exemple, les couches 17 comportent les plongeurs 18 d'excitation des cornets d'antennes 15 et 16 et les liaisons de ces plongeurs aux circuits qui sont juste en amont (en général des déphaseurs, s'il s'agit d'antennes à balayage électronique). Bien entendu, les antennes en question peuvent être des antennes-réseaux composées d'un grand nombre de cornets (ou de tout autre type d'antennes : dipôles, patches, ...) et l'on peut former des guides d'ondes dans des couches de la structure, le plus près possible des antennes.

Les autres couches de la structure 11 peuvent comporter des circuits électroniques complexes : réseaux de déphaseurs, circuits d'émission-réception, alimentation, ... ou bien elles peuvent être des couches de rigidification ou des couches dans lesquelles sont intégrés des éléments électromécaniques ou optiques. Bien entendu, s'il y a besoin d'assurer des connexions électriques entre circuits de couches différentes, ces connexions sont réalisées de façon similaire à celle utilisée pour connecter entre eux des circuits appartenant à des faces ou couches différentes d'une structure classique simple ou multicouches de circuits imprimés.

Les différentes couches de la structure de l'invention peuvent être assemblées entre elles par tout moyen approprié : soudage, collage, serrage mécanique, etc.... Cette structure peut soit être logée à l'intérieur d'une enveloppe existante, soit constituer par ses couches externes cette enveloppe, ces couches externes et les faces latérales des autres couches étant usinées et/ou recouvertes d'un matériau approprié pour constituer l'enveloppe, qui peut être facilement profilée pour assurer la continuité aérodynamique avec les surfaces environnantes (surfaces extérieures des voilures, des « pods », ... s'il s'agit d'un avion) et assurer l'étanchéité nécessaire, le cas échéant.

On a représenté en figure 6, de façon très simplifiée, un exemple de volume 19 à forme plus complexe que celui décrit ci-dessus. Ce volume 19 comporte une première portion de volume 20, similaire à la portion 8 de la figure 2, et un autre volume 21 formant un appendice sur une des faces sensiblement planes du volume 20. Cet appendice 21 a également, en section, un profil en « U » dont les branches sont, par exemple, perpendiculaires à la surface du volume 20 sur laquelle est formé cet appendice. Les strates de la structure multicouches 22 occupent seulement le volume 20 et sont parallèles à ses surfaces planes, tandis que le volume 21 est occupé par une structure multicouches 23 dont les surfaces des couches sont perpendiculaires à celles des couches de la structure 22. On a schématiquement représenté en 24 des connexions réalisées directement, de façon appropriée, entre les circuits de la structure 22 et ceux de la structure 23.

La structure conforme à l'invention permet non seulement d'utiliser de façon optimale des volumes restreints, et/ou de formes complexes, mais aussi d'y intégrer le maximum possible d'éléments en utilisant des techniques d'intégration connues en soi, et de ce fait de réduire la longueur et/ou le nombre de lignes de connexion entre les différents éléments, et donc, le cas échéant, d'améliorer leurs performances grâce à cette intégration maximale, cette structure pouvant même être un élément constitutif du porteur.

## Revendications

1. Structure de circuits électroniques à encombrement optimisé en fonction du volume disponible, comportant un empilement de couches planes comprenant au moins un circuit électronique, cet empilement étant disposé dans un logement présentant une forme frontale (10) à faible rayon de courbure bordant au moins une surface plane, **caractérisée par le fait que** les plans des strates de la structure sont parallèles à cette surface plane (8) et que la partie frontale (9) de ces strates épouse le plus fidèlement possible la forme à faible rayon de courbure.

2. Structure selon la revendication 1, **caractérisée en ce qu'**elle comporte en plus des circuits électroniques (13) au moins un empilement (7, 11, 22, 23) de couches planes comprenant l'un au moins des éléments suivants : circuits électriques, circuits optiques, guides d'ondes, composants discrets (15, 16), composants intégrés (17), éléments d'isolation (12), éléments thermiques, éléments rigidifiants, éléments protecteurs, ces couches étant sensiblement parallèles aux surfaces planes les plus importantes du volume disponible (8).

3. Structure selon la revendication 1, **caractérisée en ce que** des éléments (15, 16) sont compris ou formés dans plusieurs couches successives (14).

4. Structure selon l'une des revendications précédentes, **caractérisée en ce que** ses couches ont des épaisseurs de valeurs différentes.

5. Structure disposée dans un porteur selon l'une des revendications précédentes, **caractérisée en ce qu'**eile est un élément constitutif de son porteur.

6. Structure selon l'une des revendications précédentes, pouvant être logée dans un volume (19) à plusieurs faces pratiquement planes et d'orientations différentes, **caractérisée en ce qu'**elle comprend plusieurs empilements différents (22, 23) de couches respectivement parallèles auxdites faces planes d'orientations différentes.

7. Structure selon l'une des revendications précédentes, **caractérisée en ce qu'**elle fait partie d'un radar aéroporté.

8. Structure selon l'une des revendications précédentes, **caractérisée en ce qu'**elle fait partie d'un matériel de guerre électronique.

9. Structure selon l'une des revendications précédentes, **caractérisée en ce qu'**elle fait partie d'un matériel de télécommunications.

## Patentansprüche

1. Struktur von elektronischen Schaltungen, deren Raumbedarf in Abhängigkeit vom verfügbaren Volumen optimiert ist und die einen Stapel ebener Schichten umfaßt, der wenigstens eine elektronische Schaltung enthält, wobei dieser Stapel in einem Aufnahmesitz angeordnet ist, der eine stirnseitige Form (10) mit kleinem Krümmungsradius besitzt, die wenigstens eine ebene Fläche begrenzt, **dadurch gekennzeichnet, daß** die Ebenen der Lagen der Struktur zu dieser ebenen Fläche (8) parallel sind und daß der stirnseitige Abschnitt (9) dieser Lagen sich so getreu wie möglich an die Form mit kleinem Krümmungsradius anschmiegt.

2. Struktur nach Anspruch 1, **dadurch gekennzeichnet, daß** sie zusätzlich zu den elektronischen Schaltungen (13) wenigstens einen Stapel (7, 11, 22, 23) ebener Schichten umfaßt, die wenigstens eines der folgenden Elemente enthalten: elektrische Schaltungen, optische Schaltungen, Wellenleiter, diskrete Bauelemente (15, 16), integrierte Bauelemente (17), Isolationselemente (12), thermische Elemente, Versteifungselemente und Schutzelemente, wobei diese Schichten zu den größten ebenen Flächen des verfügbaren Volumens (8) im wesentlichen parallel sind.

3. Struktur nach Anspruch 1, **dadurch gekennzeichnet, daß** die Elemente (15, 16) in mehreren aufeinanderfolgenden Schichten (14) enthalten oder gebildet sind.

4. Struktur nach einem der vorhergehenden Ansprüche, **dadurch gekennzeichnet, daß** ihre Schichten Dicken mit unterschiedlichen Werten besitzen.

5. Struktur, die in einem Träger angeordnet ist, nach einem der vorhergehenden Ansprüche, **dadurch gekennzeichnet, daß** sie ein konstitutives Element ihres Trägers ist.

6. Struktur nach einem der vorhergehenden Ansprüche, die in einem Volumen (19) mit mehreren im wesentlichen ebenen Flächen mit unterschiedlichen Orientierungen untergebracht werden kann, **dadurch gekennzeichnet, daß** sie mehrere verschiedene Stapel (22, 23) aus Schichten besitzt, die jeweils zu den ebenen Flächen mit unterschiedlichen Orientierungen parallel sind.

7. Struktur nach einem der vorhergehenden Ansprüche, **dadurch gekennzeichnet, daß** sie einen Teil eines Flugzeug-Radars bildet.

8. Struktur nach einem der vorhergehenden Ansprüche, **dadurch gekennzeichnet, daß** sie einen Teil einer elektronischen Waffe bildet.

9. Struktur nach einem der vorhergehenden Ansprüche, **dadurch gekennzeichnet, daß** sie einen Teil eines Telekommunikationsgerätes bildet.

## Claims

1. Electronic circuits structure whose spatial requirement is optimized as a function of the volume available, comprising a stack of plane layers comprising at least one electronic circuit, this stack being arranged in a housing exhibiting a front shape (10) with small radius of curvature bordering at least one plane surface, **characterized in that** the planes of the strata of the structure are parallel to this plane surface (8) and that the front part (9) of these strata matches the shape with small radius of curvature as faithfully as possible.

2. Structure according to Claim 1, **characterized in that** in addition to the electronic circuits (13) it comprises at least one stack (7, 11, 22, 23) of plane layers comprising one at least of the following elements: electrical circuits, optical circuits, waveguides, discrete components (15, 16), integrated components (17), insulation elements (12), thermal elements, stiffening elements, protective elements, these layers being substantially parallel to the biggest plane surfaces of the volume available (8).

3. Structure according to Claim 1, **characterized in that** elements (15, 16) are included or formed in several successive layers (14).

4. Structure according to one of the preceding claims, **characterized in that** its layers have thicknesses of different values.

5. Structure arranged in a carrier according to one of the preceding claims, **characterized in that** it is a constituent element of its carrier.

6. Structure according to one of the preceding claims, which can be housed in a volume (19) having several almost plane faces of different orientations, **characterized in that** it comprises several different stacks (22, 23) of layers respectively parallel to the said plane faces of different orientations.

7. Structure according to one of the preceding claims, **characterized in that** it forms part of an airborne radar.

8. Structure according to one of the preceding claims, **characterized in that** it forms part of electronic warfare hardware.

9. Structure according to one of the preceding claims, **characterized in that** it forms part of telecommunications hardware.
